Europäisches Patentamt

European Patent Office

Office européen des brevets

(19)

(11) Veröffentlichungsnummer: **0 179 230**
**A2**

(12) # EUROPÄISCHE PATENTANMELDUNG

(21) Anmeldenummer: 85110775.5

(22) Anmeldetag: 27.08.85

(51) Int. Cl.4: **H01L 29/743** , H01L 29/10

(30) Priorität: 27.09.84 DE 3435550

(43) Veröffentlichungstag der Anmeldung:
30.04.86 Patentblatt 86/18

(84) Benannte Vertragsstaaten:
DE FR GB IT SE

(71) Anmelder: **Siemens Aktiengesellschaft**
**Berlin und München Wittelsbacherplatz 2**
**D-8000 München 2(DE)**

(72) Erfinder: **Herberg, Helmut, Dr. Dipl.-Phys.**
**Bruderhofstrasse 30a**
**D-8000 München 70(DE)**

(54) **Thyristor mit erhöhter dI/dt-Festigkeit.**

(57) Thyristor mit einem Halbleiterkörper (1), der einen in einer ersten Hauptfläche (1a) mit einem ersten Kontakt versehenen n-Emitter, eine an diesen angrenzende p-Basis, einen in einer zweiten Hauptfläche (1b) mit einem zweiten Kontakt versehenen p-Emitter und eine an diesen angrenzende n-Basis aufweist. Eine hohe dI/dt-Festigkeit wird dadurch erreicht, daß einer der Emitter aus einer Mehrzahl von Emittergebieten (7) besteht, daß die angrenzende Basis aus einer Mehrzahl von inselförmigen Basisgebieten (5) gebildet ist und daß jedem der letzteren ein Feldeffekttransistor (T1) zugeordnet ist, über den ein Zündstromkreis für ein in das Basisgebiet jeweils eingefügtes Emittergebiet (7) verläuft. Die Feldeffekttransistoren (T1) aller Basisgebiete (5) werden zum Zwecke der Zündung über einen gemeinsamen Gateanschluß (16) angesteuert. Das Anwendungsgebiet umfaßt Geräte der Leistungselektronik.

EP 0 179 230 A2

Die Erfindung bezieht sich auf einen Thyristor mit erhöhter dI/dt-Festigkeit nach dem Oberbegriff des Patentanspruchs 1.

Ein solcher Thyristor ist beispielsweise aus dem von A. Hoffmann und K. Stocker bearbeiteten Thyristor-Handbuch, Verlag Siemens AG, Berlin und München, 1965, S. 27 und 28, bekannt. Er enthält ein kreisringförmiges Hilfsemittergebiet, das einen die p-Basis in der einen Hauptfläche kontaktierenden zentralen Zündkontakt umgibt. Der n-Emitter weist ebenfalls eine Kreisringstruktur auf, die das Hilfsemittergebiet umgibt. Hierbei geht jedoch der Zündvorgang vor allem wegen der Breite des n-Emitters im allgemeinen nicht so schnell vor sich, daß bei einem sehr schnellen Anstieg des zwischen dem n-Emitter und dem p-Emitter fließenden Laststroms eine thermische Zerstörung des Thyristors sicher vermieden werden könnte.

Der Erfindung liegt die Aufgabe zugrunde, einen Thyristor der eingangs genannten Art anzugeben, bei dem dieser Nachteil nicht auftritt. Das wird erfindungsgemäß durch eine Ausbildung desselben nach dem kennzeichnenden Teil des Patentanspruchs 1 erreicht.

Der mit der Erfindung erzielbare Vorteil liegt insbesondere darin, daß eine Aufteilung des einen Emitters in eine Mehrzahl von Emittergebieten, eine Aufteilung der angrenzenden Basis in eine Mehrzahl von inselförmigen Basisgebieten und eine Aufteilung eines den Zündstrom zuführenden, in den Halbleiterkörper integrierten Transistorschalters in eine Mehrzahl von einzelnen Feldeffekttransistoren vorgenommen wird. Diese Teilstrukturen sind dann an einer Hauptfläche des Thyristors jeweils so angeordnet, daß jedes Emittergebiet von einem inselförmigen Basisgebiet umgeben ist und jedes der letzteren mit einem zur Zuführung des Zündstromes dienenden Feldeffekttransistor in Zusammenhang steht. Hierdurch wird ein wesentlich schnellerer Ablauf des Zündvorgangs erreicht als bei dem bekannten Thyristor. Daraus folgt eine wesentliche Erhöhung der Empfindlichkeit gegenüber großen Anstiegsgeschwindigkeiten des Laststroms, d.h. eine wesentliche Erhöhung der dI/dt-Festigkeit des Thyristors.

Die Patentansprüche 2 bis 5 betreffen vorteilhafte Ausgestaltungen und Weiterbildungen der Erfindung.

Die Erfindung wird nachfolgend anhand der Zeichnung näher erläuter. Dabei zeigt:
Fig. 1 ein erstes Ausführungsbeispiel der Erfindung,
Fig. 2 ein zweites Ausführungsbeispiel und
Fig. 3 eine Draufsicht auf einen nach Fig. 2 ausgebildeten Tyristor.

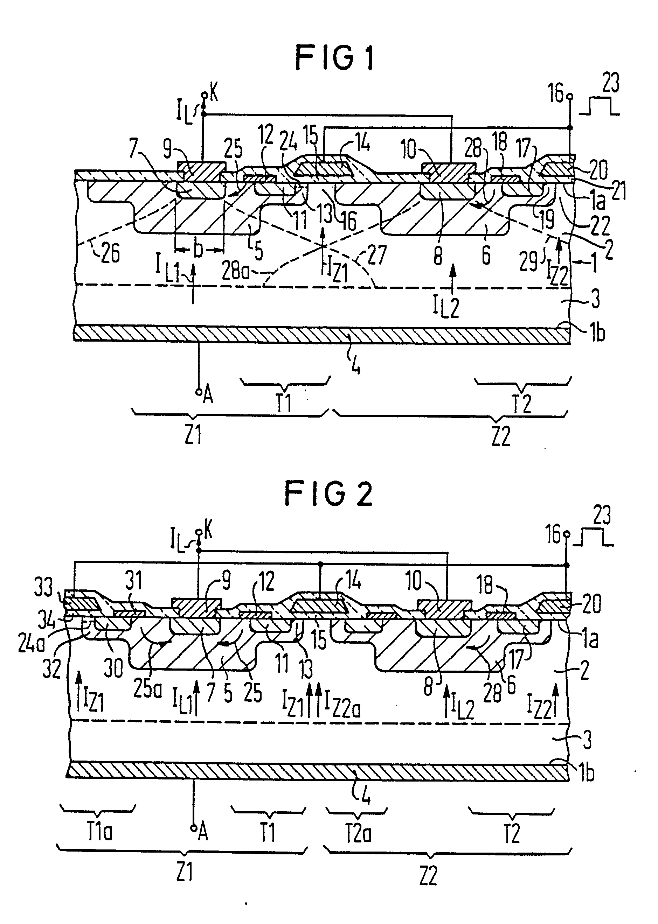

In Fig. 1 ist ein Teil eines Thyristors dargestellt, der einen scheibenförmigen Halbleiterkörper 1 aus dotiertem Halbleitermaterial, z.B. Silizium, aufweist. Er enthält eine n-Basisschicht 2 und eine p-Emitterschicht 3, die in einer Hauptfläche 1b von 1 mit einem an einen Anodenanschluß A gelegten Anodenkontakt 4 versehen ist. Die n-Basisschicht 2, deren Dotierungskonzentration etwa $10^{14}cm$ beträgt, erstreckt sich bis zu einer Hauptfläche 1a von 1. Die p-Basis des Thyristors besteht aus einer Mehrzahl von inselförmigen p-Basisgebieten, die in die n-Basisschicht 2 so eingefügt sind, daß sie sich jeweils bis zur Hauptfläche 1a erstrecken. Zwei von diesen p-Basisgebieten sind mit 5 und 6 bezeichnet. Der n-Emitter besteht aus einer Mehrzahl von n-leitenden Emittergebieten, die jeweils in die p-Basisgebiete so eingefügt sind, daß sie sich bis zur Hauptfläche 1a erstrecken. In Fig. 1 ist das in das p-Basisgebiet 5 eingefügte n-Emittergebiet mit 7 bezeichnet, das in das p-Basisgebiet 6 eingefügte mit 8. Die n-Emittergebiete 7, 8, die in der Hauptfläche 1a etwa eine Dotierungskonzentration von z.B. $10^{20}cm$ in der Hauptfläche 1a jeweils mit Kontaktteilen 9, 10 versehen, die mit einem Kathodenanschluß K verbunden sind. Die Dotierungskonzentration der p-Basisgebiete, z.B. 5, beträgt dort, wo sie an die eingefügten Emittergebiete, z.B. 7, angrenzen, z.B. $10^{17}cm$ . Auch in den sich nach links und rechts anschließenden, nicht dargestellten Teilen des Halbleiterkörpers 1 sind solche inselförmigen p-Basisgebiete vorgesehen, in die ebenfalls n-Emittergebiete eingefügt sind, wobei letztere wieder mit Kontaktteilen versehen sind, die mit K verbunden sind. Die untereinander leitend verbundenen Kontaktteile, z.B. 9, 10, aller dieser n-Emittergebiete bilden den Kathodenkontakt des Thyristors.

In das inselförmige p-Basisgebiet 5 ist das n-leitende Sourcegebiet 11 eines n-Kanal-Feldeffekttransistors T1 eingefügt, daß sich ebenfalls bis zur Hauptfläche 1a erstreckt und in dieser mit einer leitenden Belegung 12 versehen ist, die in Richtung auf das n-Emittergebiet 7 so weit verlängert ist, daß es die laterale Begrenzung des Gebietes 11 überragt und das p-Basisgebiet 5 kontaktiert. Eine Randzone 13 des p-Basisgebiets 5, die sich bis an die Hauptfläche 1a und bis an den rechten Rand des Sourcegebiets 11 erstreckt, wird von einer Gateelektrode 14 überdeckt, die durch eine dünne elektrisch isolierende Schicht 15 von der Hauptfläche 1a getrennt ist und mit einem Gateanschluß 16 verbunden ist. Der an die Randzone 13 rechtsseitig angrenzende Teilbereich 16 der n-Basisschicht 2 bildet das Draingebiet von T1. T1 stellt eine dem n-Emittergebiet 7 zugeordnete Teilstruktur eines Transistorschalters dar, über die, wie weiter unten eingehend erläutert wird, beim Anlegen eines positiven Zündspannungsimpulses 23 an den Anschluß 16 ein Zündstromkreis wirksam geschaltet wird, der vom Anodenanschluß A zum Kathodenanschluß K verläuft.

Analog hierzu ist in das inselförmige p-Basisgebiet 6 das n-leitende Sourcegebiet 17 eines n-Kanal-Feldeffekttransistors T2 eingefügt, das mit einer leitenden Belegung 18 versehen ist, die das p-Basisgebiet 6 kontaktiert. Zu T2 gehört weiterhin die Randzone 19 des Gebiets 6, die von einer Gateelektrode 20 überdeckt wird. Diese Gateelektrode ist durch eine dünne· elektrisch isolierende Schicht 21 von der Grenzfläche 1a getrennt und mit dem Gateanschluß 16 verbunden. Das Draingebiet von T2 wird von dem Teilgebiet 22 der n-Basisschicht 2 gebildet. T2 stellt eine dem n-Emittergebiet 8 zugeordnete Teilstruktur des Transistorschalters dar, über die beim Anlegen des positiven Zündspannungsimpulses 23 an den Anschluß 16 ein zweiter Zündstromkreis wirksam geschaltet wird, der vom Anodenanschluß A zum Kathodenanschluß K verläuft.

Die Teile 7, 5 und 11 bis 16 gehören zu einer ersten Thyristorzone Z1, die einen über T1 verlaufenden Zündstromkreis aufweist. In analoger Weise gehören die Teile 8, 6 und 17 bis 22 zu einer zweiten Thyristorzone Z2, die einen über T2 verlaufenden Zündstromkreis enthält. Die weiteren, im einzelnen nicht dargestellten inselförmigen p-Basisgebiete bilden weitere Thyristorzonen, die entsprechend Z1 und Z2 aufgebaut sind und jeweils neben einem n-Emittergebiet einen als Teilstruktur des Transistorschalters aufzufassenden randseitigen Feldeffekttransistor enthalten, über den ein zugeordneter Zündstromkreis wirksam geschaltet wird, der zwischen den Anschlüssen A und K verläuft.

Nach einer bevorzugten Ausgestaltung der Erfindung sind die n-Emittergebiete 7, 8 usw., die Sourcegebiete 11, 17 usw., die p-Basisgebiete 5, 6 usw. und die kontaktierenden Teile 9, 10, 12, 18, 14, 20 usw. jeweils streifenförmig ausgebildet, wobei ihre Abmessungen in einer etwa senkrecht zur Bildebene von Fig. 1 verlaufenden Richtung größer sind als in der Bildebene. Auch die Thyristorzonen, z.B. Z1 und Z2, weisen hierbei eine Streifenform auf.

Bei dem in Fig. 1 dargestellten Ausführungsbeispiel ist zwischen jeweils zwei n-Emittergebieten, z.B. 7 und 8, jeweils ein Feldeffekttransistor, z.B. T1, angeordnet, über den ein Zündstromkreis zu dem einen der beiden n-Emittergebiete, z.B. 7, hin verläuft.

Mit Vorteil ist die Breite b eines n-Emittergebiets, z.B. 7, gemessen in Richtung auf das benachbarte n-Emittergebiet, z.B. 8, kleiner gewählt als der laterale Abstand zwischen diesen beiden Emittergebieten, z.B. 7 und 8. In Fig. 1 beträgt b etwa 1/5 dieses Abstandes. Es hat sich gezeigt, daß im stromführenden Zustand des Thyristors eine so starke Auffächerung der jeweils zwischen den n-Emittergebieten 7, 8, usw. und der p-Emitterschicht 3 auftretenden Strompfade erfolgt, das bei einer gegebenen Anzahl von n-Emittergebieten eine sich aus dieser Bemessung von b ergebende Verringerung der Hauptfläche 1a des Thyristors ausgenützt werden kann, ohne eine nennenswerte Verringerung des maximal zulässigen Laststroms in Kauf nehmen zu müssen. Insbesondere kann die Breite b ohne wesentliche Verringerung des maximal zulässigen Laststroms um etwa eine Größenordnung kleiner gewählt werden als der genannte laterale Abstand. Bei einem solchen Abstand von z.B. 100 µm kann die Breite b z.B. auf 10 µm reduziert werden. Die Breite der Sourcegebiete, z.B. 11, wird zweckmäßigerweise der Breite der n-Emittergebiete, z.B. 7, angeglichen. Die Dicke des Thyristors zwischen seinen beiden Hauptflächen 1a und 1b sollte dabei vorzugsweise größer sein als der halbe laterale Abstand zweier benachbarter n-Emittergebiete, z.B. 7 und 8, voneinander.

Im blockierten Zustand des Thyristors liegt z.B. eine Spannung von 1000 Volt zwischen den Anschlüssen A und K, wobei der Anschluß A ein positiveres Potential aufweist als K. Wenn man nun den positiven Zündspannungsimpuls 23 bei 16 anlegt, so bildet sich in der Randzone 13 unterhalb der Gateelektrode 14 eine Inversionsschicht 24 aus, die einen leitenden Kanal zwischen dem Sourcegebiet 11 und dem Draingebiet 16 darstellt. Über diesen fließt ein Zündstrom $I_{Z1}$ vom Anschluß A zum Sourcegebiet 11 und von diesem über die leitende Belegung 12 in Richtung des Pfeiles 25 zum pn-Übergang zwischen den Teilen 7 und 5. Das n-Emittergebiet 7 injiziert daraufhin negative Ladungsträger in das p-Basisgebiet 5, die in Richtung auf die p-Emitterschicht 3 transportiert werden und am pn-Übergang zwischen den Schichten 2 und 3 eine Injektion von positiven Ladungsträgern in die n-Basisschicht 2 bewirken. Die aus 7 injizierten negativen Ladungsträger bilden zusammen mit den aus 3 injizierten, positiven Ladungsträgern eine sog. Speicherladung, die sich nach dem Abbau der Raumladungszone am pn-Übergang zwischen den Teilen 5 und 2 auf das p-Basisgebiet 5 und die n-Basisschicht 2 verteilt. Die lateralen Grenzen dieser Speicherladung werden durch die gestrichelten Linien 26 und 27 angedeutet, wobei die Leitfähigkeit des Halbleiterkörpers 1 innerhalb der Grenzen 26 und 27 wesentlich größer ist als das der Grunddotierung der Teile 5 und 2 entsprechen würde. Hieraus resultiert ein Last stromanteil $L_{11}$, der Thyristorzone Z1, der zwischen den Anschlüssen A und K fließt.

In analoger Weise wird durch den Zündspannungsimpuls 23 in der Thyristorzone Z2 ein Zündstrom $I_{Z2}$ hervorgerufen, der dem pn-Übergang zwischen den Teilen 8 und 6 über den leitend geschalteten Transistor T2 längs des Pfeiles 28 zugeführt wird. Hieraus resultiert in der Thyristorzone Z2 ein Laststromanteil $I_{L2}$. Die Laststromanteile $I_{L1}$ und $I_{L2}$ setzen sich mit den entsprechenden Laststromanteilen weiterer Thyristorzonen zum Laststrom $I_L$ des Thyristors zusammen.

Von wesentlicher Bedeutung ist hierbei, daß der Zündspannungsimpuls 23 in sämtlichen Thyristorzonen, z.B. Z1 und Z2, praktisch gleichzeitig Zündströme $I_{Z1}$, $I_{Z2}$ usw. hervorruft, die praktisch gleichzeitig Laststromanteile $I_{L1}$, $I_{L2}$, usw. entstehen lassen. Das bedeutet aber, daß die Zündung des Thyristors wegen der Verteilung der einzelnen Thyristorzonen, z.B. Z1 und Z2, auf die ganze Haupfläche 1a die letztere praktisch gleichzeitig erfaßt, so daß ein sehr schneller Ablauf des Zündvorgangs gewährleistet ist. Auch ein Laststrom $I_L$ mit einem sehr großen dI/dt-Wert, d.h. mit einer sehr großen Stromanstiegsgeschwindigkeit, kann damit sicher geschaltet werden.

Durch das Auftreten der Speicherladung 26, 27 verringert sich der Durchlaßwiderstand der vom Zündstrom $I_{Z1}$ durchflossenen Teile der Schichten 2 und 3, was während des Anliegens des Zündspannungsimpulses 23 eine entsprechende Vergrößerung von $I_{Z1}$ zur Folge hat. Entsprechendes gilt auch für die Zündströme $I_{Z2}$ usw. der übrigen Thyristorzonen Z2 usw., in denen ebenfalls Speicherladungen auftreten.

Diese Wirkungen der Speicherladungen können noch dadurch gesteigert werden, daß für jeweils zwei nebeneinanderliegende Thyristorzonen, z.B. Z1 und Z2, der Durchlaßwiderstand der Schichten 2 und 3 für den Zündstrom, z.B. $I_{Z1}$, der einen Thyristorzone, zB. Z1, nicht nur durch Speicherladung unterhalb des zugehörigen n-Emittergebiets, z.B. 7, sondern auch durch die Speicherladung, z.B. 28a, 29, unterhalb des n-Emittergebiets, z.B. 8, der anderen Thyristorzone, z.B. Z2, verringert wird. Das tritt dann ein, wenn sich die betreffenden Speicherladungen gemäß Fig. 1 gegenseitig überlappen. Um eine Überlappung zu erzielen, ist es zweckmäßig, den lateralen Abstand zwischen den n-Emittergebieten, z.B. 7 und 8, zweier benachbarter Thyristorzonen, z.B. Z1 und Z2, so zu wählen, daß er etwa dem lateralen Abstand zwischen dem n-Emittergebiet der einen Thyristorzone, z.B. Z1, und der Randzone z.B. 13, des diesem zugeordneten Feldeffekttransistors, z.B. T1, entspricht.

Fig. 2 zeigt ein zweites Ausführungsbeispiel der Erfindung, bei dem in das inselförmige p-Basisgebiet 5 außer dem Sourcegebiet 11 ein zweites Sourcegebiet 30 eingefügt ist, das in der Hauptfläche 1a mit einer leitenden Belegung 31 versehen ist, die in Richtung auf das n-Emittergebiet 7 derart verlängert ist, daß sie den pn-Übergang zwischen 30 und 5 überragt und das Gebiet 5 kontaktiert. Eine Randzone 32 des Gebiets 5, die sich bis zur Hauptfläche 1a und bis an den linken Rand des Sourcegebiets 30 erstreckt, wird von einer Gateelektrode 33 überdeckt, die durch eine dünne elektrisch isolierende Schicht 34 von 1a getrennt ist. Die Gateelektrode 33 ist zusammen mit den bisher beschriebenen Gateelektroden 14 und 20 an den gemeinsamen Gateanschluß 16 gelegt. In Fig. 2 sind die bereits beschriebenen Teile mit den gleichen Bezugszeichen versehen, wie in Fig. 1.

Über den aus den Teilen 30, 32, 2, 3, 33, 34 und 31 gebildeten Feldeffekttransistor T1a wird ein Zündstrom $I_{Z1a}$ dem n-Emittergebiet 7 zugeführt, was durch den Pfeil 25a angedeutet ist. Der sich beim Anlegen des Zündspannungsimpulses 23 unerhalb von 33 ausbildende Inversionskanal, über den der Zündstromkreis für $I_{Z1a}$ verläuft, ist mit 24a bezeichnet. In entsprechender Weise ist ein weiterer Feldeffekttransistor T2a am linken Rand des inselförmigen p-Basisgebiets 6 angeordnet, über den ein Zündstrom $I_{Z2a}$ dem n-Emittergebiet 8 zugeführt wird.

Zweckmäßigerweise ist die Gateelektrode 14 den Transistoren T1 und T2a gemeinsam. Auch die übrigen, nicht dargestellten p-Basisgesbiete weisen bei diesem Ausführungsbeispiel jeweils einen zusätzlichen Feldeffekttransistor auf.

Die anhand von Fig. 1 erläuterten Maßnahmen zur Reduzierung der Breite b der einzelnen n-Emittergebiete, z.B. 7, im Verhältnis zum lateralen Abstand zwischen zwei einander benachbarten n-Emittergebieten, z.B. 7 und 8, sind auch auf die Anordnung nach Fig. 2 anwendbar. Ebenso gilt die oben erwähnte Bemessungsregel für die Mindestdicke des Halbleiterkörpers 1 zwischen den Hauptflächen 1a und 1b, die größer sein soll als der halbe laterale Abstand zwischen zwei einander benachbarten n-Emittergebieten, z.B. 7 und 8.

Nach einer ersten Ausgestaltung der Anordnung nach Fig. 2 sind die Gebiete 7, 8, 11, 17 und 30 sowie die Teile 9, 10, 12, 14, 18, 20, 31 und 33 streifenförmig ausgebildet, wobei ihre Abmessungen in einer etwa senkrecht zur Bildebene von Fig. 2 verlaufenden Richtung größer sind als in dieser Bildebene.

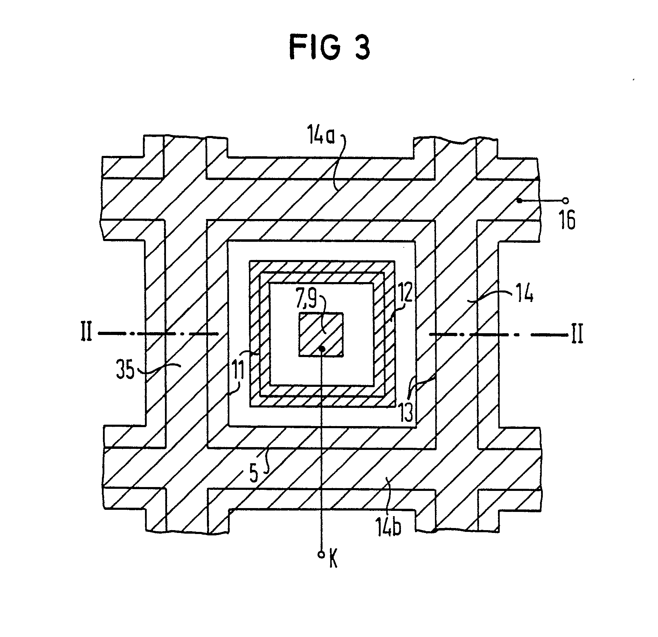

Eine zweite bevorzugte Ausgestaltung ist der in Fig. 3 dargestellten Draufsicht auf den Thyristor nach Fig. 2 zu entnehmen. Danach weist das n-Emittergebiet 7 in der Hauptfläche 1a eine quadratische oder rechteckige Form auf. Das Kontaktteil 9 weist in Fig. 3 die gleichen lateralen Begrenzungen auf wie das Gebiet 7 und ist schraffiert dargestellt. Das Sourcegebiet 11 und die Randzone 13 verlaufen entlang der Seitenlinien eines Quadrates oder Rechtecks und sind in sich geschlossen, so daß sie das Gebiet 7 von allen Seiten umgeben. Die leitende Belegung 12, die in Fig. 3 schraffiert dargestellt ist, umgibt das Gebiet 7 ebenfalls von allen Seiten. Die Gateelektrode 14 stellt einen Teil eines Elektrodengitters 14, 14a, 14b und 35 dar, das ebenfalls schraffiert ist. In jedem der quadratischen oder rechteckigen Zwischenräume des Elektrodengitters von Fig. 3 befindet sich eine der Thyristorzonen Z1, Z2 usw.. Hieraus ergibt sich ein Zellenkonzept des Thyristors. Die Fig. 2 zeigt einen Querschnitt durch den in Fig. 3 dargestellten Thyristor längs der strichpunktierten Linie II - II.

Neben den bisher beschriebenen Ausführungsformen der Erfindung sind auch solche von Interesse, bei denen die bisher genannten Halbleitergebiete jeweils durch solche des entgegengesetzten Leitfähigkeitstyps ersetzt sind, wobei anstelle der bisher genannten Spannungen bzw. Ströme solche des entgegengesetzten Vorzeichens verwendet werden. In diesen Fällen sind auch die Bezeichnungen der Anschlüsse A und K miteinander zu vertauschen.

**Ansprüche**

1. Thyristor mit einem Halbleiterkörper, der einen in einer ersten Hauptfläche mit einem ersten Kontakt versehenen n-Emitter, eine an den n-Emitter angrenzende p-Basis, einen in einer zweiten Hauptfläche mit einem zweiten Kontakt versehenen p-Emitter und eine an den p-Emitter angrenzende und von der p-Basis durch einen pn-Übergang getrennte n-Basis aufweist, **dadurch gekennzeichnet, daß** einer der Emitter aus einer Mehrzahl von Emittergebieten (7) besteht, die mit untereinander elektrisch leitend verbundenen Kontaktteilen (9) versehen sind, daß die an diesen Emitter angrenzende Basis aus einer Mehrzahl von inselförmigen Basisgebieten (5) besteht, in die die Emittergebiete (7) jeweils eingefügt sind, daß einem inselförmigen Basisgebiet (5) jeweils wenigstens ein Feldeffekttransistor (T1) zugeordnet ist, wobei dieser aus einem in das inselförmige Basisgebiet (5) eingefügten, den gleichen Leitfähigkeitstyp wie das in dieses Basisgebiet (5) eingefügte Emittergebiet (7) aufweisenden Sourcegebiet (11), aus einer sich bis zu einer Hauptfläche (1a) und bis an den Rand des Sourcegebiets (11) erstreckenden Randzone (13) des inselförmigen Basisgebiets (5), aus einer die Randzone (13) überdeckenden und durch eine dünne, elektrisch isolierende Schicht (15) von der Hauptfläche (1a) getrennten Gateelektrode (14) und aus einem an die Randzone (13) angrenzenden Teilgebiet (16) der an das inselförmige Basisgebiet (5) angrenzenden Basis (2) besteht, daß das Sourcegebiet (11) mit einer elektrisch leitenden Belegung (12) versehen ist, die das inselförmige Basisgebiet (5) kontaktiert, und daß die Gateelektroden (14) aller Feldeffekttransistoren (T1) mit einem gemeinsamen Gateanschluß (16) verbunden sind.

2. Thyristor nach Anspruch 1, **dadurch gekennzeichnet, daß** die Breite (b) eines Emittergebiets (7), gemessen in Richtung auf ein benachbartes Emittergebiet (8), kleiner ist als der laterale Abstand zwischen diesen beiden Emittergebieten (7, 8).

3. Thyristor nach Anspruch 2, **dadurch gekennzeichnet, daß** die Breite (b) eines Emittergebiets (7), gemessen in Richtung auf ein benachbartes Emittergebiet (8), um eine Größenordnung kleiner ist als der laterale Abstand zwischen diesen beiden Emittergebieten (7, 8).

4. Thyristor nach einem der vorhergehenden Ansprüche, **dadurch gekennzeichnet, daß** die Dicke des Halbleiterkörpers (1) zwischen beiden Hauptflächen (1a, 1b) größer ist als der laterale Abstand zwischen einem Emittergebiet (7) und einer in demselben inselförmigen Basisgebiet (5) wie dieses angeordneten Randzone (13) eines Feldeffekttransistors (T1).

5. Thyristor nach einem der vorhergehenden Ansprüche, **dadurch gekennzeichnet, daß** jedes in einem inselförmigen Basisgebiet (5) vorgesehene Emittergebiet (7) von einem Sourcegebiet (11) umgeben ist, das seinerseits von der Randzone (13) dieses inselförmigen Basisgebiets (5) umgeben ist, daß das Sourcegebiet (11) und die Randzone (13) etwa entlang der Seitenlinien eines Rechtecks verlaufen und daß zwischen den nebeneinander angeordneten Randzonen (13) einer Mehrzahl von inselförmigen Basisgebieten (5) ein Gitter aus Gateelektroden (14, 14a, 14b, 33) angeordnet ist.

FIG 1

FIG 2

# FIG 3